Europäisches Patentamt

European Patent Office

Office européen des brevets

(11) Veröffentlichungsnummer: **0 327 820**
**A2**

## EUROPÄISCHE PATENTANMELDUNG

(21) Anmeldenummer: **89100447.5**

(22) Anmeldetag: **12.01.89**

(51) Int. Cl.⁴: **H03M 1/12**

(30) Priorität: **12.02.88 DE 3804329**

(43) Veröffentlichungstag der Anmeldung:
**16.08.89 Patentblatt 89/33**

(84) Benannte Vertragsstaaten:
**AT FR GB IT**

(71) Anmelder: **ANT Nachrichtentechnik GmbH**
**Gerberstrasse 33**
**D-7150 Backnang(DE)**

(72) Erfinder: **Sattel, Wolfgang, Dipl.-Ing.**
**Bahnhofstrasse 9**
**D-7141 Kirchberg/Murr(DE)**

(54) **Verfahren zum Umsetzen von Bitkombinationen in ein PPM-Wort-Signal und Anordnungen zum Durchführen des Verfahrens.**

(57) Verfahren zum Umsetzen von Bitkombinationen in ein PPM-Wort-Signal, bei dem jedes Bit einer Kombination seriell getrennt zunächst gespeichert wird, daß der Speicherinhalt getrennt parallel auf die Eingänge eines Demultiplexers gegeben wird, der an seinen Ausgängen ein durch die Belegung der Eingänge bestimmtes Bitmuster parallel ausgibt, das durch einen Parallel-Serien-Umsetzer in ein serielles Muster umgewandelt wird und Anordnung zum Durchführen.

Xerox Copy Centre

# Verfahren zum Umsetzen von Bitkombinationen in ein PPM-Wort-Signal und Anordnungen zum Durchführen des Verfahrens

Die vorliegende Erfindung betrifft ein Verfahren zum Umsetzen von Bitkombinationen mit m Bits in ein PPM(Pulse-Position-Modulation)-Wort-Signal mit n Zeitschlitzen und Anordnungen zum Durchführen des Verfahrens.

Aufgabe der Erfindung ist es, ein einfaches Verfahren zur Codierung einer Bitkombination in ein PPM-Signal und eine Anordnung zum Durchführen des Verfahrens anzugeben. Diese Aufgabe wird gelöst, wie in den Patentansprüchen beschrieben.

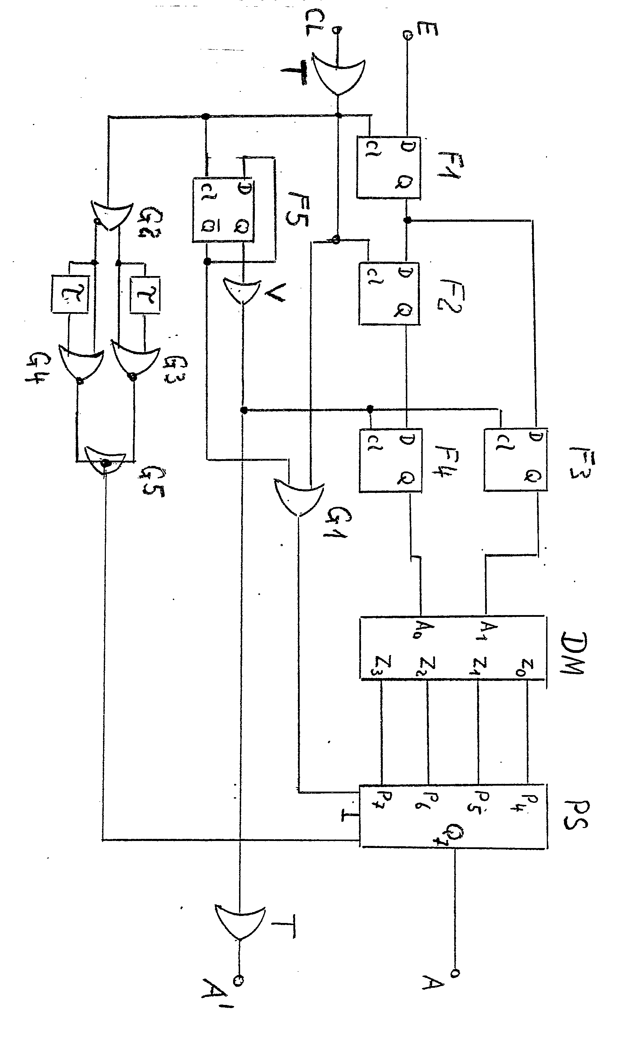

Die Erfindung soll jetzt anhand der Figur näher erläutert werden. An dem Eingang E liegt in dem Ausführungsbeispiel ein aus einem Bitpaar bestehendes Signal. Das erste Bit dieses Paares wird zunächst gespeichert in dem Flip-flop F2, das zweite Bit im Flip-flop F1. Durch die Weitergabe an die Flip-flops F3 bzw. F4 wird dann das seriell angekommene Bitpaar in ein paralleles Bitpaar umgewandelt. Die Ausgänge Q der Flip-flops F3 und F4 geben das Parallelsignal entsprechend auf die Eingänge des Demultiplexers DM. Dieser Demultiplexer DM schaltet entsprechend der vorliegenden Eingangskombination einen der 4 Ausgänge $Z_0$ - $Z_3$ nach seinem vorgegebenen Muster durch. Die Ausgänge $Z_0$ - $Z_3$ sind mit den Eingängen $P_4$ - $P_7$ eines Parallel-Serien-Umsetzers PS verbunden, an dessen Ausgang A das an den Ausgängen $Z_0$ - $Z_3$ entstandene parallele Signal, in ein serielles umgewandelt, abgegeben wird. Der Worttakt für das am Ausgang A abgegebene Signal wird gewonnen aus dem Takt des am Eingang E anliegenden Bitpaares, dadurch daß dieser Takt um den Faktor 2 geteilt wird (F5). Dieser Takt muß allerdings noch um einen bestimmten Betrag verzögert werden, da in der vorher geschilderten Verarbeitung des Eingangssignals dieser Worttakt dazu benutzt wird, die Flip-Flops F3 und F4 zur Serien-Parallel-Wandlung und den Parallel-Serien-Wandler PS zu synchronisieren. Zum Gewinnen des Zeitschlitztaktes, der zum Betreiben des Parallel-Serien-Wandlers PS benötigt wird, wird der Takt des Eingangssignals zunächst in ein Komplementärsignal umgewandelt durch das Gatter G2. Das Taktsignal und das komplementäre Taktsignal werden jeweils direkt bzw. verzögert auf je einen Eingang einer als Oder-Schaltung wirkenden logischen Schaltung (G3 = NOR-Gatter, G4 = NOR-Gatter, G5 = Wired-OR-Gatter) gegeben. Daraus entsteht das Zeitschlitztaktsignal.

## Ansprüche

1. Verfahren zum Umsetzen von Bitkombinationen mit m Bits in ein PPM(Pulse-Position-Modulation)-Wort-Signal mit n Zeitschlitzen, dadurch gekennzeichnet, daß jedes Bit einer Kombination seriell getrennt in m Speichern zunächst gespeichert wird, daß der Speicherinhalt getrennt parallel auf die m Eingänge eines Demultiplexers gegeben wird, der an seinen n Ausgängen ein durch die Belegung der Eingänge bestimmtes Bitmuster parallel ausgibt, das durch einen Parallel-Serien-Umsetzer in ein serielles Muster umgewandelt wird.

2. Verfahren nach Anspruch 1, dadurch gekennzeichnet, daß aus dem Taktsignal für die Bitkombination durch Teilung durch den Faktor m der Worttakt und durch Vervielfachung um den Faktor n/m der Zeitschlitztakt gewonnen wird.

3. Anordnung zum Durchführen des Verfahren nach Anspruch 1, dadurch gekennzeichnet, daß an den Eingang der Schaltung die Reihenschaltung zweier Flip-Flops (F1, F2) gelegt ist, wobei der Ausgang des ersten Flip-Flops (F1) auf den Eingang eines dritten (F3), und der Ausgang des zweiten (F2) auf den Eingang eines vierten (F4) geschaltet ist, daß die Ausgänge der dritten und vierten Flip-Flops (F3, F4) auf die Eingänge (A0, A1) eines Demultiplexers (DM) gelegt sind, dessen Ausgänge ($Z_0$ - $Z_3$) an die Eingänge ($P_4$ - $P_7$) eines Parallel-Serien-Wandlers (PS) angeschlossen sind.

4. Anordnung zum Durchführen des Verfahrens nach Anspruch 2, dadurch gekennzeichnet, daß dem Takteingang (CL) ein rückgekoppeltes Flip-Flop (F5) nachgeschaltet ist, an dessen Ausgang Q bzw. A' der geteilte Takt anliegt, daß weiter dem Takteingang (CL) ein Gatter mit einem invertierenden und einem nichtinvertierenden Ausgang nachgeschaltet ist, daß an diese beiden Ausgänge je ein Eingang einer als Oder-Schaltung wirkenden logischen Schaltung direkt und je ein Eingang über ein Verzögerungsglied ($\tau$) angeschlossen sind, so daß am Ausgang der Schaltung der Zeitschlitztakt anliegt.

BK 88/15